# EUROPÄISCHE PATENTANMELDUNG

(11) **EP 1 098 135 A2**
(43) Veröffentlichungstag der Anmeldung: **09.05.2001**
(21) Anmeldenummer: 00115816.1
(22) Anmeldetag: 22.07.2000
(51) Int. Cl.: F21S 8/10

(54) **Fahrzeugleuchte**

(30) Priorität: 04.11.1999 DE 19953132
(71) Anmelder: VALEO Beleuchtung Deutschland GmbH, 74321 Bietigheim-Bissingen (DE)
(72) Erfinder: Lendle, Reiner, 74855 Haamersheim (DE); Wellhäusser, Martin, 74343 Sachsenheim (DE)
(74) Vertreter: Dreiss, Fuhlendorf, Steimle & Becker

(57) **Zusammenfassung**

Die Erfindung geht aus von einer Fahrzeugleuchte (1) mit einem Leuchtmittelträger (13) und mit auf dem Leuchtmittelträger vorhandenen LED's (12) als Leuchtmittel.

Die erfindungsgemäße Fahrzeugleuchte (1) kennzeichnet sich dadurch, dass die Fahrzeugleuchte wenigstens ein lösbar angeordnetes Leuchtmodul (8,8',9,9',10) aufweist, dass das Leuchtmodul (8,8',9,9',10) als Leuchtmittel mehrere LED's (12) aufweist, dass das Leuchtmodul (8,8',9,9',10) einen Leuchtmittelträger (13) aufweist, dass das Leuchtmodul (8,8',9,9',10) eine undemontierebare Leuchtmodulverkleidung (14,14') aufweist und dass das Leuchtmodul (8,8',9,9',10) eine lösbare elektrische Verbindung zur Stromversorgung der LED's (12) aufweist.

## Beschreibung

Die Erfindung betrifft eine Fahrzeugleuchte mit einem Fahrzeugleuchtengehäuse, mit einem Leuchtmittelträger und mit auf dem Leuchtmittelträger vorhandenen Leuchtdioden (LED) als Leuchtmittel.

Solche Fahrzeugleuchten sind aus dem Stand der Technik bekannt und weisen den Vorteil auf, dass sie trägheitslos arbeiten, eine lange Lebensdauer aufweisen, einen geringen Leistungsverbrauch haben, mechanisch stabil sind und eine geringe Betriebstemperatur haben. Aufgrund der geringen Lichtstärke von LED's ist in Fahrzeugleuchten, die LED's als Leuchtmittel einsetzen, eine recht hohe Anzahl von LED's notwendig. LED's weisen allerdings den Nachteil auf, dass sie im Vergleich zu herkömmlichen Leuchtmitteln mit gleicher Lichtstärke, wie beispielsweise Glühbirnen, höhere Herstellungskosten haben. Fahrzeugleuchten, insbesondere Fahrzeugheckleuchten, die eine große Anzahl von LED's benötigen, sind damit vergleichsweise teuer.

Ein weiterer Nachteil von Fahrzeugleuchten, die LED's einsetzen, ist, dass die einzelnen LED's nicht austauschbar sein dürfen, um vorgegebene Lichtwerte einer Fahrzeugleuchte nicht verändern zu können. Dies ist insbesondere deshalb von Bedeutung weil die Lichtstärken von LED's weder standardisiert noch normiert sind und deshalb LED's mit verschiedenen Lichtstärken erhältlich sind.

Bei Ausfall eines LED's einer Fahrzeugleuchte ist es deshalb erforderlich, die komplette Leuchte gegen eine neue Leuchte auszutauschen. Teilweise existieren auch Leuchten, bei denen vorgesehen ist, den kompletten Leuchtmittelträger mit allen darauf vorhandenen LED's gegen einen neuen Leuchtmittelträger auszutauschen. Aufgrund der großen Anzahl von LED's ist ein entsprechendes Ersatzteil entsprechend teuer. Fahrzeugleuchten mit einer großen Anzahl von LED's als Leuchtmittel sind daher nur sehr bedingt wirtschaftlich.

Außerdem besteht das Problem, dass bei Leuchten, bei denen der Leuchtmittelträger austauschbar ist, in der Regel die LED's zugänglich sind und an diesen maipuliert werden kann, bzw. diese können durch andere LED'S ersetzt werden können. Diese laut Gesetz unzulässigen Manipulationen lassen sich durch den bekannten Stand der Technik nicht zulässig vermeiden.

Der Erfindung liegt deshalb die Aufgabe zugrunde eine Fahrzeugleuchte mit LED's vorzuschlagen, bei der ein kostengünstiges Auswechseln von Leuchtmittelträgern möglich ist, ohne dass die Gefahr unzulässiger manipulation besteht. Außerdem soll die Möglichkeit geschaffen werden, dass bei Ausfall eines LED's nicht der gesamte Leuchtmittelträger mit darauf vorhandenen LED's ausgetauscht werden muss. Eine damit verbundene Kosteneinsparung kann dazu führen, dass Fahrzeugleuchten mit einer Vielzahl von LED's wirtschaftlich eingesetzt werden können.

Zur Lösung der Aufgabe wird eine Fahrzeugleuchte der eingangs beschriebenen Art vorgeschlagen, die vorsieht, dass die Fahrzeugleuchte lösbar angeordnete Leuchtmodule aufweist, dass die Leuchtmodule als Leuchtmittel mehrere LED's aufweisen, dass die Leuchtmodule Leuchtmittelträger aufweisen, dass die Leuchtmodule eine undemontierbare Leuchtmodulverkleidung aufweisen und dass die Leuchtmodule eine lösbare elektrische Verbindung zur Stromversorgung der LED's aufweisen.

Die erfindungsgemäße Fahrzeugleuchte weist den Vorteil auf, dass bei Ausfall eines LED's nicht sämtliche LED's mit dem Leuchtmittelträger ausgetauscht werden müssen, sondern lediglich das Leuchtmodul, in welchem die auszutauschende LED's angeordnet sind. Aufgrund der geringen Anzahl von auszutauschenden LED's sind die entsprechenden Leuchtmodule vergleichsweise kostengünstig.

Dadurch, dass im Versagensfall eines LED's lediglich ein Leuchtmodul ausgetauscht werden muss, müssen auch nur die in dem Leuchtmodul vorhandenen LED's entsorgt werden. Die Erfindung trägt damit zu einer Umweltentlastung bei.

Für die Zulassung von Fahrzeugleuchten mit LED's als Leuchtmittel ist gesetzlich vorgeschrieben, dass die Leuchtmittel nicht zugänglich oder manipulierbar sein dürfen. Deshalb ist erfindungsgemäß vorgesehen, dass die LED's von einer nicht demontierbaren Leuchtmodulverkleidung umgeben sind.

Aufgrund der lösbaren elektrischen Verbindung zwischen den Leuchtmodulen und der Fahrzeugleuchte ist ein Austauschen eines Leuchtmoduls auf einfache Art und Weise möglich.

Nach einer Ausgestaltung der Erfindung weist die Fahrzeugleuchte wenigstens zwei lösbar angeordnete Leutmodule auf, wobei die Leuchtmodule innerhalb einer Fahrzeugleuchte identisch oder unterschiedlich sind. Je nach Anforderungsprofil an die Fahrzeugleuchte können identische oder unterschiedliche Leuchtmodule vorteilhaft sein. In einer Fahrzeugheckleuchte können so beispielsweise Leuchtmodule als Blinkleuchtmodule, als Rücklichtleuchtmodule und als Bremslichtleuchtmodule vorgesehen sein.

Bei einer anderen Ausgestaltung der Erfindung ist vorgesehen, dass innerhalb eines Leuchtmoduls identische oder unterschiedliche LED's vorhanden sind. Welche LED's Verwendung finden, hängt dabei davon ab, für welchen Zweck das Leuchtmodul eingesetzt werden soll.

Eine Variante der Erfindung sieht vor, dass die Leuchtmodulverkleidung im Bereich der LED's Durchbrüche aufweist. Eine solche Ausgestaltung ist dann von Vorteil, wenn die Lichtstärke der LED's nicht durch die Leuchtmittelverkleidung beeinträchtigt werden soll.

Nach einer anderen Weiterbildung der Erfindung sind die Durchbrüche von trichterartigen, in Richtung zu den LED's sich verengenden Abschnitten der Leuchtmodulverkleidung umgeben. Solche trichterartigen Abschnitte gewährleisten ein Abstrahlen der LED's in die gewünschte Richtung. Außerdem kann durch eine entsprechende Dimensionierung der sich in Richtung LED's verengenden Abschnitte gewährleistet werden, dass die LED's in dem Leuchtmodul funktionssicher gehalten werden und nicht demontierbar sind.

Bei einer anderen Ausgestaltung der Erfindung ist die Leuchtmodulverkleidung wenigstens abschnittsweise transparent und weist ggf. eine Optik auf. Dadurch kann das Abstrahlverhalten der LED's entsprechend beeinflusst werden, wodurch gewünschte Eigenschaften der Fahrzeugleuchte erreichbar sind.

Eine andere Ausgestaltung sieht vor, dass die LED's innerhalb den Leuchtmodulen nebeneinander in einer Reihe angeordnet sind. Gerade durch eine solche Anordnung kann ein einfaches Austauschen der Leuchtmodule erreicht werden.

Bei einer Variante der Erfindung ist die elektrische Verbindung eine Steckverbindung. Eine Steckverbindung kann auf einfache Art und Weise realisiert werden und ist kostengünstig.

Eine andere vorteilhafte Ausgestaltung der Erfindung kennzeichnet sich dadurch, dass die Leuchtmodule mittels lösbaren Rast- und/oder Schnappverbindungen in der Fahrzeugleuchte gehalten werden. Solche Schnappverbindungen sind einfach und kostengünstig in der Herstellung und gewährleisten ein funktionssicheres Halten der Leuchtmodule in der Fahrzeugleuchte.

Eine Weiterbildung der Erfindung sieht vor, dass die Fahrzeugleuchte und/oder die Leuchtmodule Rast- und/oder Schnappelemente aufweisen. Solche Rast- und/oder Schnappelemente dienen zur Verwirklichung der Schnappverbindung zwischen der Fahrzeugleuchte und den Leuchtmodulen.

Bei einer anderen Ausgestaltung der Erfindung ist der Leuchtmittelträger aus Kunststoff. Aufgrund der geringen Betriebstemperatur von Leuchtdioden kann ein solcher Leuchtmittelträger, der günstig in der Herstellung ist, Verwendung finden.

Weitere vorteilhafte Ausgestaltungen und Einzelheiten der Erfindung sind der folgenden Beschreibung zu entnehmen, in der die Erfindung anhand des in der Zeichnung dargestellten Ausführungsbeispiels näher beschrieben und erläutert ist.

Es zeigen:
- Figur 1: eine Draufsicht auf die Heckpartie eines Fahrzeuges,
- Figur 2: einen denkbaren Schnitt entlang der Linie A/A der Figur 1 und
- Figur 3: einen anderen denkbaren Schnitt entlang der Linie B/B der Figur 1.
- Figuren 4 u. 5: zwei Querschnitte durch zwei verschiedene Leuchtmodule

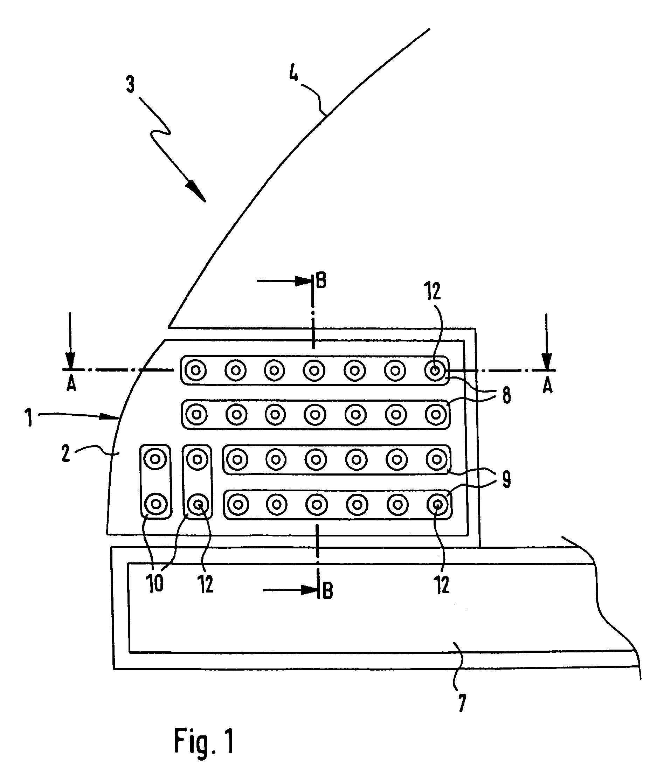

In der Figur 1 ist eine Fahrzeugleuchte 1 mit einem Fahrzeugleuchtengehäuse 2 dargestellt, die an der Heckpartie eines Fahrzeugs 3 angeordnet ist. Die Fahrzeugleuchte 1 ist dabei von einer Heckklappe 4 sowie einem Stoßfänger 7 umgeben. Außerdem weist die Fahrzeugleuchte 1 verschiedene Leuchtmodule 8, 9 und 10 auf. In den Leuchtmodulen 8 sind dabei je sieben LED's 12, in den Leuchtmodulen 9 je sechs LED's 12 und in den Leuchtmodulen 10 je zwei LED's 12 angeordnet.

Wie aus Figur 1 deutlich erkennbar ist, sind innerhalb der Fahrzeugleuchte 1 drei unterschiedliche Leuchtmodule 8, 9 und 10 vorhanden. Dabei kann beispielsweise vorgesehen sein, dass die Leuchtmodule 10 als Blinkleuchtmodule, die Leuchtmodule 9 als Rücklichtleuchtmodule und die Leuchtmodule 8 als Bremslichtleuchtmodule vorgesehen sind. Vorzugsweise sind innerhalb der Leuchtmodule 8, 9 oder 10 der Fahrzeugleuchte 1 identische LED' s 12 vorhanden.

Bei Ausfall eines LED's innerhalb eines Leuchtmoduls wird erfindungsgemäß lediglich das Leuchtmodul ausgetauscht, welches das defekte LED 12 aufweist. Da nicht sämtliche, die Fahrzeugleuchte 1 beinhaltenden LED's 12 ausgetauscht werden müssen, können aufgrund des Austauschs von lediglich einzelnen Leuchtmodulen 8, 9 oder 10 Kosten eingespart werden.

Die LED's 12 der Leuchtmodule 8, 9 und 10 sind innerhalb den Leuchtmodulen 8, 9 und 10 nebeneinander in einer Reihe angeordnet.

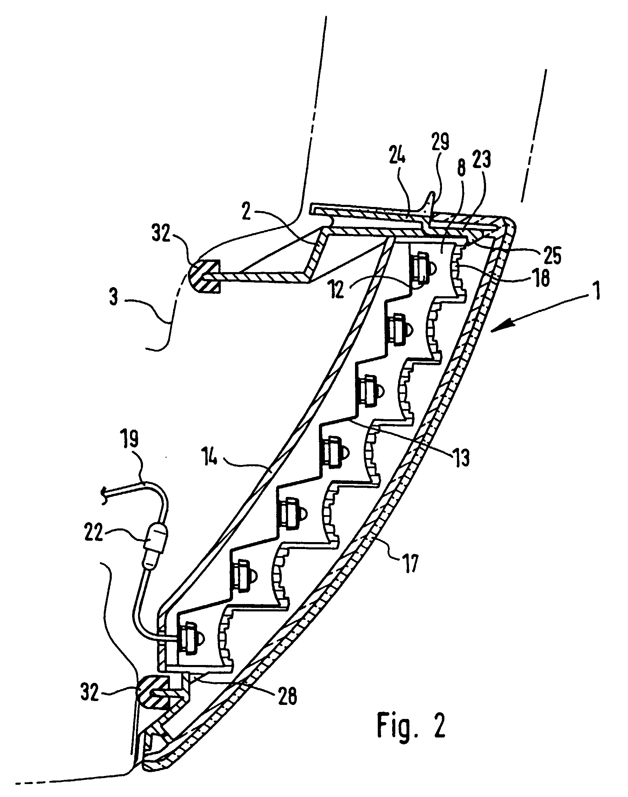

In der Figur 2 ist ein möglicher Schnitt entlang der Linie A/A nach Figur 1 durch ein Leuchtmodul 8 dargestellt. Dabei ist deutlich zu erkennen, wie die einzelnen LED's 12 auf einem Leuchtmittelträger 13, beispielsweise auf einem Leiterblech oder einer Leiterplatine, angeordnet sind. Der Leuchtmittelträger 13 mit den darauf angeordneten LED's 12 ist von einer Leuchtmodulverkleidung 14 umgeben, die undemontierbar ist. Damit soll vermieden werden, dass einzelne LED's 12 von dem Leuchtmittelträger 13 entfernt werden können, und durch andere, ggf. unzulässigen LED's ersetzt werden.

Das Fahrzeugleuchtengehäuse 2 weist an seiner dem Fahrzeug 3 abgewandten Seite ein Außenglas 17 auf. Die dem Außenglas 17 zugewandte Seite der Leuchtmodulverkleidung 14 ist im Bereich der LED's 12 transparent ausgestaltet und weist eine Optik 18 auf, durch welche eine gewünschte Brechung des von den LED's 12 emittierten Lichts erreicht wird.

Das Leuchtmodul 8 nach Figur 2 weist außerdem eine lösbare elektrische Verbindung 19 auf, nämlich eine Steckverbindung 22. Bei einer anderen Ausgestaltung der Erfindung kann auch vorgesehen sein, dass die Steckerlitze unmittelbar an der Leuchtmodulverkleidung 14 vorhanden sind, welche bei Montage des Leuchtmoduls 8 in einen an beispielsweise der Fahrzeugleuchte 1 vorhandenen Gegenstecker steckbar sind. Auch jede andere Art der Kontaktierung ist denkbar.

Die Figur 2 zeigt außerdem, dass das Leuchtmodul 8 mittels einer lösbaren Rast- und Schnappverbindung 23 in der Fahrzeugleuchte 1 gehalten wird. Dazu weist die Fahrzeugleuchte 1 ein Schnappelement 24 mit einer Rastnase 25 auf, welche die Leuchtmodulverkleidung 14 hinterschnappt. Auf der dem Schnappelement 24 abgewandten Seite der Leuchtmodulverkleidung 14 ist eine Abstütznase 28 vorhanden, welche ebenfalls das Leuchtmodul 8 an der Fahrzeugleuchte 1 abstützt.

Zur Abdichtung der Fahrzeugleuchte 1 an der Karosserie des Fahrzeugs 3 weist die Fahrzeugleuchte 1 zwei Dichtgummis 32 auf.

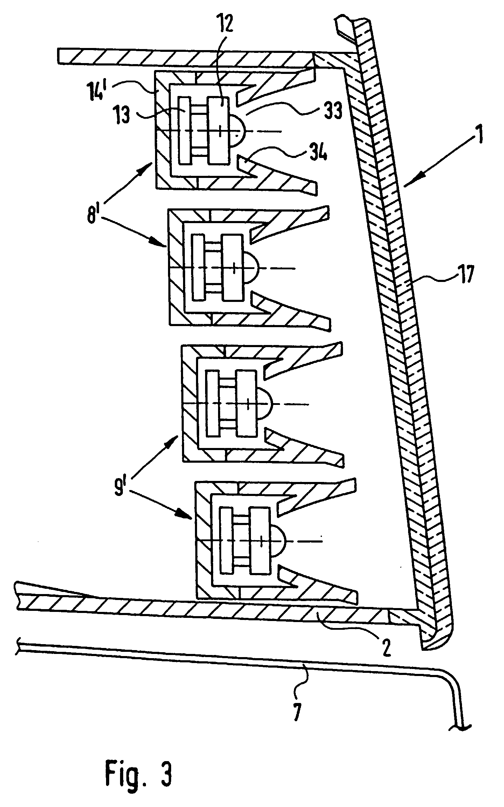

In der Figur 3 ist ein Schnitt entlang der Linie B/B nach Figur 1 durch eine anders ausgestaltete Fahrzeugleuchte gezeigt. Deutlich zu erkennen sind vier Querschnitte durch vier Leuchtmodule 8', 8' und 9', 9'. Die vier gezeigten LED's 12 sind jeweils auf einem Leuchtmittelträger 13 angeordnet. Die Leuchtmittelträger 13 mit den LED's 12 sind jeweils von einer Leuchtmodulverkleidung 14' umgeben, welche nicht demontierbar ist und damit einen Austausch oder ein Manipulieren von einzelnen LED's nicht zulässt. Die Leuchtmodulverkleidungen 14' weisen im Bereich der LED's 12 Durchbrüche 33 auf. Die Durchbrüche 33 sind von trichterartigen, in Richtung zu den LED's 12 sich verengenden Abschnitten 34 der Leuchtmodulverkleidung 14' umgeben. Aufgrund der trichterartigen Abschnitte 34 der Leuchtmodulverkleidungen 14' wird ein gezieltes Abstrahlen der LED's 12 in die gewünschte Richtung gewährleistet.

Außerdem kann durch eine entsprechende Dimensionierung der sich in Richtung LED's 12 verengenden Abschnitte 34 gewährleistet werden, dass die LED's 12 in den Leuchtmodulen 8' und 9' funktionssicher gehalten werden und nicht demontierbar sind.

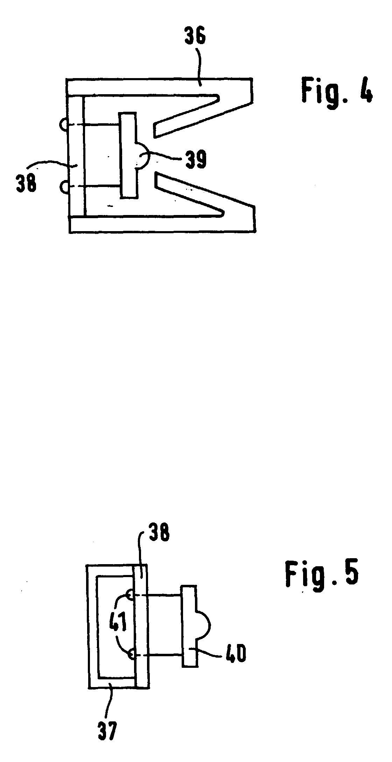

Wie in Figur 4 und 5 dargestellt ist, kann die Leuchtmodulverkleidung 36 und 37 abweichend von den beschriebenen Ausführungsformen auch nur auf einer Seite des Leuchtmittelträgers 38 angeordnet sein, wenn dadurch eine Manipulation der LED's 39, 40 sicher vorgebeugt wird. Ein LED 39 nach Figur 4 kann aufgrund der sich in Richtunng LED 39 trichterartig verjüngenden Ausgestaltung der Leuchtmodulverkleidung 36 nicht demontiert werden. In Figur 5 kann das LED 40 aufgrund der von der Leuchtmodulverkleidung 37 abgedeckten und damit unzugänglichen Lötstellen 41 nicht ausgetauscht werden.

Alle in der Beschreibung, den nachfolgenden Ansprüchen und der Zeichnung dargestellten Merkmale können sowohl einzeln, als auch in beliebiger Kombination miteinander erfindungswesentlich sein.

## Patentansprüche

1. Fahrzeugleuchte (1) mit einem Fahrzeugleuchtengehäuse (2), mit einem Leuchtmittelträger (13) und mit auf dem Leuchtmittelträger (13) vorhandenen LEDs (12) als Leuchtmittel, **dadurch gekennzeichnet, dass** die Fahrzeugleuchte wenigstens ein lösbar angeordnetes Leuchtmodul (8, 8', 9, 9', 10) aufweist, dass das wenigstens eine Leuchtmodul (8, 8', 9, 9', 10) als Leuchtmittel mehrere LEDs (12) aufweist, dass das Leuchtmodul (8, 8', 9, 9', 10) einen Leuchtmittelträger (13) aufweist, dass das Leuchtmodul (8, 8', 9, 9', 10) eine undemontierbare Leuchtmodulverkleidung (14, 14') aufweist und dass das Leuchtmodul (8, 8', 9, 9', 10) eine lösbare elektrische Verbindung zur Stromversorung der LED's (12) aufweist.

2. Fahrzeugleuchte (1) nach Anspruch 1, dadurch gekennzeichnet, dass die Fahrzeugleuchte wenigstens zwei lösbar angeordnete Leuchtmodule aufweist und dass die Leuchtmodule (8, 8', 9, 9', 10) innerhalb einer Fahrzeugleuchte (1) identisch oder unterschiedlich sind.

3. Fahrzeugleuchte (1) nach Anspruch 1 oder 2, dadurch gekennzeichnet, dass innerhalb eines Leuchtmoduls (8, 8', 9, 9', 10) identische oder unterschiedliche LEDs (12) vorhanden sind.

4. Fahrzeugleuchte (1) nach Anspruch 1, 2 oder 3, dadurch gekennzeichnet, dass die Leuchtmodulverkleidung (14') im Bereich der LEDs (12) Durchbrüche (33) aufweist.

5. Fahrzeugleuchte (1) nach Anspruch 4, dadurch gekennzeichnet, dass die Durchbrüche (33) von trichterartigen, in Richtung zu den LEDs (12) sich verengenden Abschnitten (34) der Leuchtmodulverkleidung (14') umgeben sind.

6. Fahrzeugleuchte (1) nach einem der vorhergehenden Ansprüche, dadurch gekennzeichnet, dass die Leuchtmodulverkleidung (14) wenigstens abschnittsweise transparent ist und ggf. eine Optik (18) aufweist.

7. Fahrzeugleuchte (1) nach einem der vorhergehenden Ansprüche, dadurch gekennzeichnet, dass die Leuchtmodulverkleidung wenigstens abschnittsweise opak ist und ggf. einen Reflektor aufweist.

8. Fahrzeugleuchte (1) nach einem der vorhergehenden Ansprüche, dadurch gekennzeichnet, dass die LEDs (12) innerhalb eines Leuchtmoduls (8, 8', 9, 9', 10) nebeneinander in einer Reihe angeordnet sind.

9. Fahrzeugleuchte (1) nach einem der vorhergehenden Ansprüche, dadurch gekennzeichnet, dass die elektrische Verbindung eine Steckverbindung (22) ist.

10. Fahrzeugleuchte (1) nach einem der vorhergehenden Ansprüche, dadurch gekennzeichnet, dass die Leuchtmodule (8, 8', 9, 9', 10) mittels lösbaren Rast- und/oder Schnappverbindungen (23) in der Fahrzeugleuchte (1) gehalten werden.

11. Fahrzeugleuchte (1) nach einem der vorhergehenden Ansprüche, dadurch gekennzeichnet, dass die Fahrzeugleuchte (1) und/oder die Leuchtmodule (8, 8', 9, 9', 10) Rast- und/oder Schnappelemente (24) aufweist.

12. Fahrzeugleuchte (1) nach einem der vorhergehenden Ansprüche, dadurch gekennzeichnet, dass der Leuchtmittelträger (13) aus Kunststoff ist.
